# EUROPÄISCHE PATENTANMELDUNG

(11) **EP 1 394 848 A2**
(43) Veröffentlichungstag der Anmeldung: **03.03.2004**
(21) Anmeldenummer: 03019398.1
(22) Anmeldetag: 27.08.2003
(51) Int. Cl.: H01L 21/66, H01L 21/311

(54) **Ätzverfahren und Ätzsignalschicht zur Prozessierung von Halbleiterwafern**

(30) Priorität: 30.08.2002 DE 10240106
(71) Anmelder: Infineon Technologies AG, 81669 München (DE)
(72) Erfinder: Hecht, Thomas, 01099 Dresden (DE); Schroeder, Uwe, 01109 Dresden (DE); Seidl, Harald, 85622 Feldkirchen (DE); Gutsche, Martin, 84405 Dorfen (DE); Jakschik, Stefan, 01309 Dresden (DE); Kudelka, Stefan, 01458 Ottendorf-Okrilla (DE); Birner, Albert, 01129 Dresden (DE)
(74) Vertreter: Müller - Hoffmann & Partner

(57) **Zusammenfassung**

Eine durch sequenzielle Gasphasenabscheidung mit einer Schichtdicke von weniger als 20 nm vorgesehene Ätzsignalschicht (2) aus einem Metalloxid oder einem Oxid seltener Erden wird zwischen einem unterliegenden Substrat (1) und einer Prozesschicht (3) vorgesehen. Die Ätzsignalschicht (2) liefert ein von abzutragenden Stapelschichtsystemen mit einer Mehrzahl von siliziumhaltigen Materialien unabhängiges Ätzsignal und ist schnell und mit geringen Prozesstoleranzen zu entfernen. Eine Substratoberfläche (10) des Substrats (1) wird topographieunabhängig geschützt. Auf der Ätzsignalschicht (2) beruhende Ätzverfahren sind präzise auszuführen und variabel einzusetzen.

## Beschreibung

Die Erfindung betrifft ein Ätzverfahren zum Abtrag von Material im Zuge einer Prozessierung von Halbleiterwafern mit den Schritten:
- Bereitstellen eines Halbleiterwafers als Substrat,
- Vorsehen einer Ätzsignalschicht mindestens auf Abschnitten einer Substratoberfläche des Substrats,
- Vorsehen einer Prozessschicht mindestens auf Abschnitten der Ätzsignalschicht,
- Abtragen von mindestens Abschnitten der Prozessschicht im Zuge eines Ätzprozesses,
- Erzeugen eines Ätzsignals bei Freilegen von den abgetragenen Abschnitten der Prozessschicht unterliegenden Abschnitten der Ätzsignalschicht und
- Beenden des Ätzprozesses in Abhängigkeit des Ätzsignals. Die Erfindung betrifft ferner eine Ätzsignalsschicht.

Eine Prozessierung von Halbleiterwafern umfasst in der Regel eine Mehrzahl von Prozessschritten mit Ätzprozessen, durch die entweder Schichten ganzflächig entfernt oder lithographisch erzeugte Maskenmuster in darunterliegende Schichten bzw. Strukturen übertragen werden.

Bei nasschemischen Ätzprozessen wird festes Material in einer chemischen Lösung aufgelöst. Bei chemisch-mechanischen Polierprozessen (chemical mechanical polishing, CMP) wird ein nasschemisches Ätzen durch mechanische Einwirkung eines Poliermittels auf die abzutragende Schicht bzw. Struktur unterstützt. In chemischen Trockenätzprozessen reagiert das abzutragende Material mit Bestandteilen eines Ätzgases unter Bildung flüchtiger Reaktionsprodukte. Im Zuge physikalischer Trockenätzprozesse wird das abzutragende Material einem Teilchenstrahl ausgesetzt, unter dessen Einwirkung das abzutragende Material verdampft bzw. einzelne Atome aus der abzutragenden Schicht bzw. Struktur herausgelöst werden. Für das reaktive Ionenätzen (reactive ion-beam etching, RIE) werden Ionen in Richtung auf das abzutragende Material beschleunigt und lösen beim Auftreffen einen chemischen Ätzprozess aus.

Isotrope Ätzprozesse, etwa nasschemisches Ätzen, tragen Material richtungsunabhängig, anisotropen Ätzprozesse wie RIE und CMP dagegen gerichtet in einer Vorzugsrichtung ab.

Die Ätzprozesse enden in der Regel an Ätzstoppschichten. Die Ätzstoppschichten werden jeweils aus einem Material vorgesehen, dass durch den jeweils verwendeten Ätzprozess nicht oder mit einer gegenüber dem abzutragenden Material sehr geringen Ätzrate zurückgebildet wird.

Üblich ist es auch, einen Ätzendpunkt durch eine Ätzstoppsignalschicht messtechnisch zu erfassen. Dazu wird etwa bei Trockenätzprozessen die bearbeitete und durch den Ätzprozess zurückgebildete Prozessfläche spektroskopisch ausgewertet oder bei nasschemischen Ätzprozessen die Ätzrate laufend erfasst und auf eine signifikante Änderung hin ausgewertet.

Das Material der Ätzstoppschicht bzw. der Ätzstoppsignalschicht wird so gewählt, dass der Ätzprozess für das abzutragende Material möglichst selektiv gegenüber dem Material der Ätzstoppschicht bzw. Ätzstoppsignalschicht ist. Zwar sind Silizium, Siliziumoxid SiO₂ und Siliziumnitrid Si₃N₄ und Silizide im Prinzip gegeneinander ätzbar. Werden siliziumhaltige Materialien als Ätzstoppschichten gegeneinander vorgesehen, so werden auch die Ätzstoppschichten vom Ätzprozess angegriffen und sind mit ausreichender Schichtdicke vorzusehen, um einen Durchgriff des Ätzprozesses in das der Ätzstoppschicht unterliegende Material zuverlässig auszuschließen. Wird als Ätzstopp- bzw. Ätzstoppsignalschicht beim Abtrag von Siliziumoxid oder Silizium Siliziumnitrid Si₃N₄ verwendet, so ist die Siliziumnitridschicht in einer Dicke von mehreren 10 Nanometern vorzusehen. Zur Unterstützung der Entfernung der Ätzstoppschicht selbst ist dann eine weitere Schutzschicht zwischen der Ätzstoppschicht und dem unterliegenden Substrat, etwa Siliziumoxid, notwendig, um bei einem Abtrag der Ätzstoppschicht das unterliegende Substrat zu schützen.

Aus der US 6,593,633 ist ein Verfahren zur Herstellung einer Halbleitereinrichtung bekannt, in dessen Verlauf eine Siliziumcarbidschicht (SiC) in einem plamaunterstützten Gasphasenabscheidungsverfahren (plasma enhanced chemical vapour deposition, PECVD) abgeschieden und als in der Folge abschnittsweise remanente Ätzstoppschicht vorgesehen wird. Nach ihrer Benutzung als Ätzstoppschicht verbleibt die Siliziumcarbidschicht abschnittsweise als Isolatorschicht niedriger Permitivität zwischen zwei zu entkoppelnden Strukturen der Halbleitereinrichtung.

In der US 6,518,671 (Yang et al.) werden als Materialien für Ätzstoppschichten Tantaloxid (Ta₂O₅) und Aluminiumoxid (Al₂O₃) genannt. Die Schichtdicke der Ätzstoppschicht beträgt 20 bis 70 nm. Die Ätzstoppschicht wird auf eine planare Oberfläche aufgebracht und photolithographisch strukturiert. Die Ätzstoppschicht begrenzt einen Materialabtrag in einem anisotropen chemisch-physikalischen Trockenätzprozess.

Der Erfindung liegt die Aufgabe zugrunde, ein Ätzverfahren zum Abtrag von Material im Zuge einer Prozessierung von Halbleiterwafern zur Verfügung zu stellen, bei dem unabhängig von einem verwendeten Ätzprozess und einer Oberflächenstruktur einer gegen den Abtrag zu schützenden unterliegenden Schicht oder Struktur eine Mehrzahl von siliziumhaltigen Materialien in einem einzügigen Ätzprozess abgetragen werden kann. Die Aufgabe umfasst es auch, eine Ätzsignalschicht für ein solches Verfahren zur Verfügung zu stellen.

Diese Aufgabe wird bei einem Verfahren der eingangs genannten Art durch die im kennzeichnenden Teil des Patentanspruchs 1 genannten Merkmale gelöst. Eine die Aufgabe lösende Ätzsignalschicht geht aus dem Anspruch 23 hervor. Vorteilhafte Weiterbildungen ergeben sich aus den jeweiligen Unteransprüchen.

Im Zuge des erfindungsgemäßen Ätzverfahrens zum Abtrag von Material im Zuge einer Prozessierung von Halbleiterwafern wird zunächst ein Halbleiterwafer als Substrat bereitgestellt. Der Halbleiterwafer weist zu diesem Zeitpunkt typischerweise bereits eine Strukturierung mit unterschiedlichen Materialien auf. Mindestens auf Abschnitten einer Substratoberfläche des Substrats wird eine Ätzsignalschicht vorgesehen. Mindestens auf Abschnitten der Ätzsignalschicht wird eine Prozessschicht vorgesehen. Die Prozessschicht ist entweder einteilig und homogen oder ein unstrukturiertes oder in sich strukturiertes Schichtsystem. Im Zuge eines Ätzprozesses wird die Prozessschicht vollständig oder in Abschnitten abgetragen. Geht die Prozessschicht beispielsweise aus einem Abscheidungsprozess hervor, in dessen Verlauf sich in das Substrat erstreckende Grabenstrukturen gefüllt werden, so wird die Prozessschicht oberhalb der Ätzsignalschicht vollständig abgetragen. Wird durch einen photolithographischen Prozess eine Primärstruktur einer Ätzmaske in die Prozessschicht abgebildet, so wird die Prozessschicht nur in Abschnitten oberhalb der Ätzsignalschicht abgetragen. Beim bzw. nach dem Freilegen von Abschnitten der Ätzsignalschicht, die den abzutragenden Abschnitten der Prozessschicht unterliegen, wird ein Ätzsignal erzeugt. In Abhängigkeit des Ätzsignals wird der Ätzprozess beendet. Das Ätzsignal ist durch eine Ätz- bzw. Poliervorrichtung auswertbar.

Erfindungsgemäß wird die Ätzsignalschicht mittels sequenzieller Gasphasenabscheidung (atomic layer deposition, ALD) oder Molekularstrahlepitaxie als dielektrische Schicht aus einem Metalloxid vorgesehen, wobei Oxide seltener Erden eingeschlossen sind.

Metalloxide bzw. Oxide seltener Erden lassen sich mit hoher Ätzselektivität gegen alle in der Halbleiterprozesstechnologie üblichen siliziumhaltigen Materialien, wie kristallines Silizium, amorphes Silizium, Siliziumdioxid und Siliziumnitrid in einem Schritt ätzen. Mittels der sequenzieller Gasphasenabscheidung lässt sich die Ätzsignalschicht auch auf strukturierten Substraten mit gleichmäßiger Schichtstärke und guter Kantenbedeckung herstellen. Per sequenzieller Gasphasenabscheidung abgeschiedene Schichten aus Metalloxid bzw. Oxiden seltener Erden sind gegen übliche chemische Ätzverfahren einerseits robust, andererseits aber gerade bei sehr geringen Schichtdicken auf mechanischem Wege, etwa durch Teilchenbeschuss, auf einfache Weise quasi zu pulverisieren und zu entfernen.

Das erfindungsgemäße Ätzverfahren ermöglicht sowohl eine Vereinheitlichung der im Zuge der Prozessierung der Halbleiterwafer notwendigen Ätzprozesse als auch eine sehr einfache Beseitigung von nur temporär genutzten Ätzsignalschichten.

In bevorzugter Weise wird die Ätzsignalschicht in einer Schichtdicke vorgesehen, bei der ein auf dem quantenmechanischen Tunneleffekt beruhender Ladungsträgertransport durch die Ätzsignalschicht noch in signifikantem Umfang möglich ist. Von einem Ladungsträgertransport in signifikantem Umfang kann abhängig von der Anwendung und dem verwendeten Material bei Stromdichten größer 10⁻⁵ A/cm² für isolierende Anwendungen und größer 10⁻² A/cm² für leitende Anwendungen ausgegangen werden.

In Verbindung mit dem Aufbringen der Ätzsignalschicht mittels der sequenziellen Gasphasenabschneidung, infolge der die Ätzsignalschicht eine nahezu gleichmäßige Schichtdicke über ihre gesamte Ausdehnung aufweist, können remanente Abschnitte der Ätzsignalschicht auch zwischen leitend miteinander zu verbindenden Strukturen im Halbleiterwafer angeordnet werden. Dadurch kann in verschiedenen Anwendungen, etwa bei der Ausbildung von vertikalen Verbindungsstrukturen (plugs) auf das Entfernen der Ätzsignalschicht verzichtet werden.

In besonders vorteilhafter Weise wird die Ätzsignalschicht mit einer Schichtdicke kleiner 20 Nanometer vorgesehen. Zwischen leitfähigen Strukturen wird dadurch ein elektrischer Übergangswiderstand zwischen den leitfähigen Strukturen in vergleichsweise geringem Umfang erhöht. Des Weiteren erfolgt das Entfernen einer Ätzsignalschicht im Vergleich zu herkömmlichen Ätzstoppschichten, wie etwa Siliziumnitridschichten, schnell und einfach. Es entfällt die Notwendigkeit, unterhalb der Ätzstoppschicht eine weitere Schutzschicht vorzusehen, die das unterliegende Substrat gegen ein Entfernen der Ätzstoppschicht schützt. Zur Ausbildung der Ätzsignalschicht geeignete Metalloxide sind etwa HfO₂, ZrO₂, Nb₂O_{5,} Ta₂O₅ und Al₂O₃. Geeignete Oxide seltener Erden sind etwa Pr₂O₅ und La₂O₃.

In bevorzugter Weise wird die Ätzsignalschicht aus einem Material gebildet, das ein in der Prozessschicht nicht enthaltenes Signalelement, etwa ein Metall, aufweist. Eine jeweils gerade dem Ätzprozess (nasschemisches, RIE, CMP) ausgesetzte Prozessfläche, die in Abhängigkeit vom Fortschritt des Ätzprozesses von der Prozessschicht und/oder der Ätzsignalschicht gebildet wird, wird spektroskopisch beobachtet und ausgewertet. Das Ätzsignal wird dann erzeugt, wenn das Signalelement spektroskopisch detektiert wird. Das Ätzsignal wird dadurch auf einfache Weise und präzise synchronisiert zum fortschreitenden Ätzprozess erzeugt.

Nach einer anderen bevorzugten Ausführungsform des erfindungsgemäßen Ätzverfahrens wird etwa bei CMP-Prozessen laufend eine Ätzrate des Ätzprozesses erfasst und ein Ätzsignal dann erzeugt, wenn sich in der Ätzrate eine signifikante Änderung, üblicherweise eine signifikante Reduzierung, ergibt.

Der Ätzprozess, ob nasschemischer Art, RIE oder CMP, kann zeitgleich mit dem Ätzsignal oder mit geringem Nachlauf beendet werden, so dass der Ätzprozess an der Oberfläche der Ätzsignalschicht stoppt. In besonders vorteilhafter Weise wird jedoch der Ätzprozess nach einer ersten Nachlaufzeit beendet, die so bemessen wird, dass während der ersten Nachlaufzeit die Ätzsignalschicht in den freigelegten Abschnitten gerade vollständig abgetragen wird. Dies ist gerade deshalb möglich, weil die Ätzsignalschicht bedingt durch ihre Erzeugung mittels sequenzieller Gasphasenabscheidung eine nahezu gleichmäßige und sehr geringe Schichtdicke aufweist. Das Entfernen der Ätzsignalschicht kann zeitlich zum vorangegangenen Ätzsignal bei sehr geringen Toleranzen gesteuert werden, so dass das unterliegende Substrat dabei nicht geschädigt wird.

Alternativ dazu wird der Ätzprozess nach Ablauf einer zweiten Nachlaufzeit beendet. Die zweite Nachlaufzeit wird dann so bemessen, dass während der zweiten Nachlaufzeit das der Ätzsignalschicht unterliegende Substrat in Abschnitten, die den freigelegten Abschnitten der Ätzsignalschicht unterliegen, bis gerade zu einer für die Anwendung erforderliche Tiefe abgetragen wird. Für diese Art der Prozessierung, etwa im Zusammenhang mit RIE- und CMP-Prozessen, ergeben sich relativ geringe Fertigungstoleranzen, da der Abtrag der Ätzsignalschicht selbst wegen ihrer geringen Schichtdicke und hohen Konformität innerhalb geringer Toleranzen erfolgt.

Weiter ist es vorteilhaft, eine erste Prozessteilschicht vor dem Vorsehen der Ätzsignalschicht auf dem Substrat und nach dem Vorsehen der Ätzsignalschicht eine zweite Prozessteilschicht mindestens auf Abschnitten der Ätzsignalschicht aufzubringen. Die zweite Nachlaufzeit kann dann so bemessen werden, dass während der zweiten Nachlaufzeit die zweite Prozessteilschicht in den Abschnitten, die den freigelegten Abschnitten der Ätzsignalschicht unterliegen, gerade vollständig abgetragen wird.

Dabei wird das durch die Ätzsignalschicht erzeugte Ätzsignal zum Feinjustieren eines auf die gesamte aus den beiden Prozessteilschichten gebildete Prozessschicht wirkenden Ätzprozesses genutzt.

Für die verschiedenen genannten Varianten ist fallweise eine Anpassung von Parametern des Ätzprozesses in Abhängigkeit von einer Detektion des Ätzsignals vorteilhaft.

Das erfindungsgemäße Ätzverfahren ist insbesondere dann vorteilhaft, wenn die Prozessschicht aus mehr als einer Stapelschicht ausgebildet wird, wobei mindestens eine der Stapelschichten mit einer Sekundärstruktur mit mehreren Stapelabschnitten aus unterschiedlichen Materialien vorgesehen sein kann. Solche Schichtsysteme, die mindestens abschnittsweise gemeinsam strukturiert bzw. oberhalb einer Ätzsignalschicht abgetragen werden, können in der Halbleiterprozesstechnologie beispielsweise im Zusammenhang mit sich in unterschiedlichen Ebenen kreuzenden Verbindungsleitungen, aber nicht nur dort, auftreten.

Die Vorteile des erfindungsgemäßen Ätzverfahrens tragen insbesondere dann, wenn das Substrat mit einem gemäß einer Grundstruktur strukturierten Relief mit Gräben und Stegen an der Substratoberfläche bereitgestellt wird. Durch das erfindungsgemäße Ätzverfahren wird sichergestellt, dass die Ätzsignalschicht auch auf der strukturierten Substratoberfläche mit hoher Gleichmäßigkeit, geringer Schichtdicke homogen und mit guter Kantenbedeckung vorgesehen wird, so dass die oben genannten Vorteile im Gegensatz zu bekannten Ätzverfahren auch für strukturierte Oberflächen erhalten bleiben.

Das erfindungsgemäße Verfahren ist für photolithographische Verfahren geeignet, im Zuge derer eine Primärstruktur einer photolithographischen Maske durch einen Ätzprozess in die Prozessschicht abgebildet wird. Dazu wird auf der Prozessschicht eine gemäß der Primärstruktur strukturierte Maske vorgesehen und durch den Ätzprozess die Primärstruktur mindestens bis in die Prozessschicht übertragen. Dabei kann die Sekundärstruktur unabhängig von der Primärstruktur und unterschiedlich zu ihr vorgesehen werden.

Der Ätzprozess ist alternativ auch als ein chemisch-mechanisches Polierverfahren durchzuführen. Im Zuge des Ätzprozesses werden dabei Abschnitte der Prozessschicht oberhalb einer Substratkante, die durch eine Oberkante eines bezüglich der Substratoberfläche höchsten Steges bestimmt wird, abgetragen.

Die Ätzsignalschicht kann fallweise auch vertikal strukturiert werden oder im Zuge des erfindungsgemäßen Ätzverfahrens bereits strukturiert abgeschieden werden.

Dazu wird in besonders bevorzugter Weise die Ätzsignalschicht mittels einer sequenziellen Gasphasenabscheidung vorgesehen, bei der eine Mehrzahl von molekularen Einzellagen nacheinander abgeschieden werden und bei der der Abscheidungsprozess so gesteuert wird, dass die Abscheidung jeder Einzellage gerichtet von der Substratkante aus in die Tiefe des Reliefs erfolgt. Die Abscheidung jeder Einzellage wird vor einer vollständigen Bedeckung des unterliegenden Substrats durch die jeweilige Einzellage vorzeitig abgebrochen. Im Ergebnis wird die Ätzsignalschicht bereits vertikal strukturiert abgeschieden, so dass eine nachträgliche vertikale Strukturierung, etwa durch Modifikation der Ätzresistenz durch Schrägimplantation von die Ätzresistenz der Ätzsignalschicht beeinflussenden Dotierstoffen, entfallen kann.

Die Ätzsignalschicht wird fallweise durch einen Temper- oder Wärmeschritt verdichtet und ausgehärtet. Im Zusammenhang mit der Rückbildung einer Prozessschicht aus siliziumhaltigen Material wird eine etwa 5 Nanometer dicke Aluminiumoxidschicht vorgesehen, die in einem Temperschritt bei 700 bis 1100 Grad Celsius mindestens 5 Sekunden bis maximal etwa 10 Stunden lang ausgehärtet wird.

Das Aluminium liefert ein eindeutiges spektroskopisches Ätzsignal. Die aus Kristalliten unterschiedlicher Kristallstruktur gebildete Aluminiumoxidschicht unterscheidet sich in ihren chemisch/physikalischen Eigenschaften so weitgehend von Silizium und Siliziumverbindungen, dass Silizium, Siliziumoxid und Siliziumnitrid gemeinsam mit hoher Ätzselektivität gegen die Ätzsignalschicht zurückgebildet werden können. Gegen übliche chemisch-physikalische Ätzprozesse ist Aluminiumoxid stabil, so dass für die Funktionalität als Ätzsignalschicht Schichtstärken von unter 20 Nanometer und unter 10 Nanometer ausreichen. Aluminiumoxidschichten von bis zu 5 Nanometer oder 10 Nanometer lassen sich auf mechanische Weise, allein durch Teilchenbeschuss quasi pulverisieren und vergleichsweise einfach und auf für das Substrat schonende Weise entfernen. Ähnliches gilt für Hafniumoxidschichten als Ätzsignalschichten.

Die Durchführung des erfindungsgemäßen Ätzverfahrens ist mit der erfindungsgemäßen Ätzsignalschicht verknüpft. Die erfindungsgemäße Ätzsignalschicht besteht aus einem Metalloxid oder Oxid seltener Erden. Die Ätzsignalschicht geht aus einer sequenziellen Gasphasenabscheidung oder einem molekular-strahlepitaktischen Verfahren hervor. Die Ätzsignalschicht ist als Schichtsystem aus einer Mehrzahl von einmolekularen Einzellagen vorgesehen. Die Schichtdicke der Ätzsignalschicht ist dadurch gekennzeichnet, dass noch ein signifikanter, auf dem quantenmechanischen Tunneleffekt beruhender Ladungsträgertransport durch die Ätzsignalschicht möglich ist. Bevorzugt beträgt die Schichtdicke weniger als 20 nm.

Nachfolgend wird die Erfindung anhand der Figuren näher erläutert. Die Figuren zeigen jeweils schematische Querschnitte durch Beispielstrukturen in einem Halbleiterwafer. Im Einzelnen zeigen:
- Fig. 1: ein erstes Ausführungsbeispiel des erfindungsgemäßen Ätzverfahrens mit anisotropen und auf der Ätzsignalschicht stoppenden Ätzprozess,
- Fig. 2: das Ausführungsbeispiel gemäß der Fig. 1 mit einem ersten Nachlauf,
- Fig. 3: das Ausführungsbeispiel der Fig. 2 mit einem zweiten Nachlauf,
- Fig. 4: ein Ausführungsbeispiel des erfindungsgemäßen Ätzverfahrens mit Feinjustierung des Ätzprozesses durch eine Ätzsignalschicht,
- Fig. 5: ein Ausführungsbeispiel des erfindungsgemäßen Ätzverfahrens für einen Abtrag mehrlagiger Strukturen,
- Fig. 6: ein Ausführungsbeispiel des erfindungsgemäßen Ätzverfahrens mit einem chemisch-mechanischen Ätzprozess,
- Fig. 7: ein Ausführungsbeispiel für das erfindungsgemäße Ätzverfahren gemäß der Fig. 6 mit einem abzutragenden Schichtsystem aus unterschiedlichen Materialien,
- Fig. 8: ein Ausführungsbeispiel des erfindungsgemäßen Ätzverfahrens mit isotropen Ätzprozess und
- Fig. 9: ein Ausführungsbeispiel des erfindungsgemäßen Verfahrens mit vertikal strukturiert abgeschiedener Ätzsignalschicht.

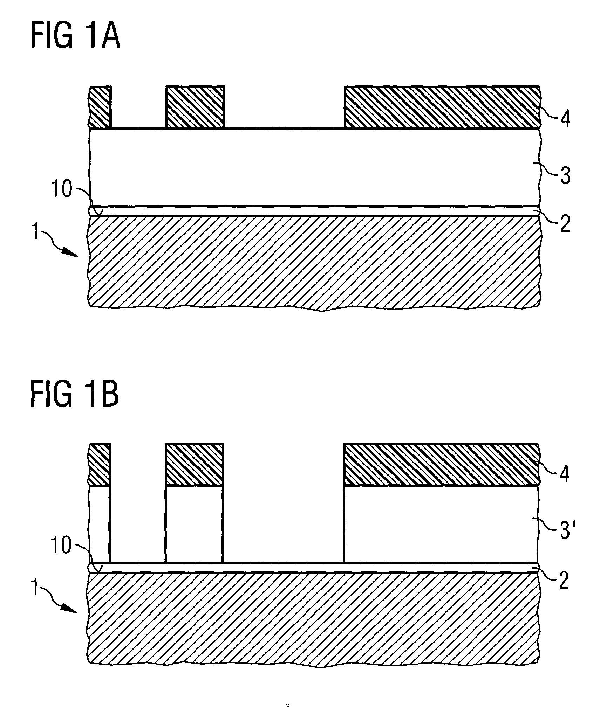

Die Fig. 1A zeigt ein Substrat 1. Das Substrat 1 besteht im dargestellten Ausschnitt aus monokristallinem Silizium, Siliziumoxid, Siliziumnitrid und/oder einem anderen in der Halbleiterprozesstechnologie üblichen Material. Das Substrat 1 ist homogen oder weist Strukturen auf, die in dieser und in den folgenden Figuren nicht dargestellt sind.

Auf einer Substratoberfläche 10 des Substrats 1 ist eine weniger als 20 nm dicke Ätzsignalschicht 2 aufgebracht. Die Ätzsignalschicht 2 wurde durch sequenzielle Gasphasenabscheidung erzeugt und besteht aus einer Mehrzahl von molekularen Einzellagen. Auf der Ätzsignalschicht 2 ist eine Prozessschicht 3 vorgesehen. Auf der Prozessschicht 3 liegt eine Ätzmaske 4 aus einem Photoresistmaterial auf, die durch einen photolithographischen Prozess strukturiert wurde.

Durch einen Ätzprozess wird die Struktur der Ätzmaske 4 in die darunterliegende Prozessschicht 3 übertragen.

Im Beispiel der Fig. 1B endet der Abtrag des Materials der Prozessschicht 3 an der Oberkante der Ätzsignalschicht 2. Die Ätzsignalschicht 2 kann wegen ihrer geringen Dicke einfach und schnell entfernt werden. Die Ätzsignalschicht 2 kann aber wegen ihren dielektrischen Charakters unterhalb einer in den freigestellten Abschnitten anschließenden dielektrischen Struktur in der Prozessschicht 3 oder oberhalb einer dielektrischen Struktur im Substrat 1 erhalten bleiben. Sie kann wegen ihrer aufgrund ihrer geringen Schichtdicke leitfähigen Eigenschaften auch dann auf der Substratoberfläche 10 verbleiben, wenn sie zwischen zwei miteinander zu verbindenden, leitfähigen Strukturen vorgesehen ist.

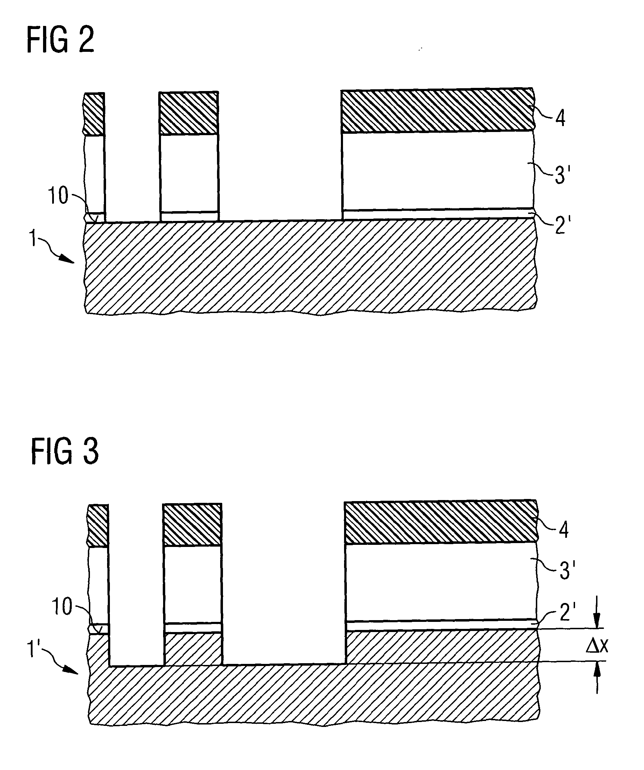

Die Fig. 2 zeigt das Ergebnis des Ätzverfahrens, wenn der Ätzprozess, gegebenenfalls bei einem Wechsel der Prozessparameter, synchronisiert zum ersten Auftreten des Ätzsignals eine vordefinierte Zeit weiterläuft, bevor er abgebrochen wird. Bedingt durch die geringe und verfahrensbedingte gleichmäßige Schichtdicke der Ätzsignalschicht 2 wird diese während der Nachlaufzeit in vergleichsweise geringer Zeit, gleichmäßig, mit geringen Toleranzen und ohne Schädigung der Substratoberfläche 10 des Substrats 1 entfernt. Es ergibt sich die in der Fig. 2 dargestellte strukturierte Ätzsignalschicht 2'.

Die geringen Ätztoleranzen beim Abtrag der Ätzsignalschicht 2 ermöglichen es auch, wie es in der Fig. 3 dargestellt ist, in einer zweiten Nachlaufzeit das Substrat 1 in den den freigelegten Abschnitten der Ätzsignalschicht 2 unterliegenden Abschnitten definiert und mit geringen Toleranzen um einen vorbestimmten Nachlauf dx zurückzubilden.

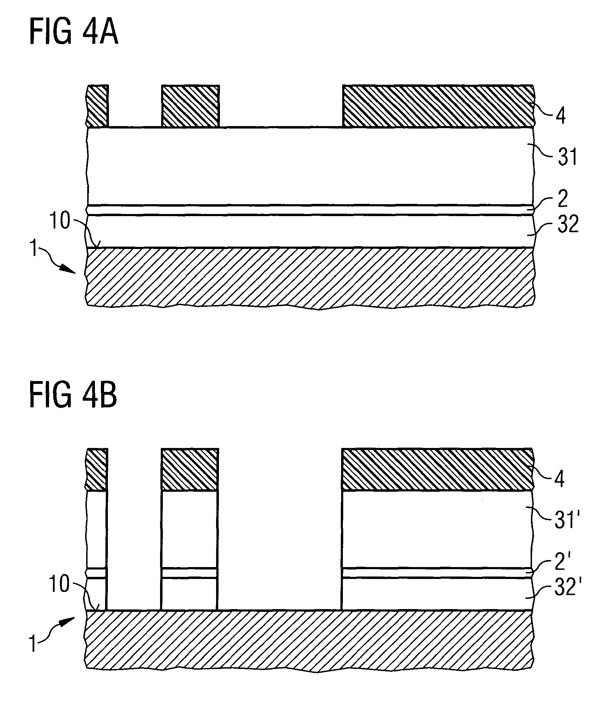

Gemäß dem in der Fig. 4 dargestellten Ausführungsbeispiel des erfindungsgemäßen Ätzverfahrens wird im Unterschied zu den vorangegangenen Beispielen die Prozessteilschicht 3 in Form zweier Prozessteilschichten 31, 32 aufgebracht, wie es in der Fig 4A dargestellt ist. Dabei unterliegt die zweite Prozessteilschicht der Ätzsignalschicht 2. Die erste Prozessteilschicht 31 liegt auf der Ätzsignalschicht 2 auf. Insbesondere dann, wenn etwa die Schichtdicke der ersten Prozessteilschicht 31 nicht präzise bekannt ist oder der Abtrag der ersten Prozessteilschicht vergleichsweise schnell erfolgen soll, kann der Abtrag der zweiten Prozessteilschicht 32 bzw. von Abschnitten davon, synchronisiert zu einem von der Ätzsignalschicht 2 generierten Ätzsignal erfolgen. Vorteilhaft ist dieses Verfahren insbesondere im Zusammenhang mit chemisch-mechanischen Polierverfahren als Ätzprozess.

In der Fig. 4B sind die durch den Ätzprozess strukturierten Prozessteilschichten 31', 32' sowie die strukturierte Ätzsignalschicht 20 dargestellt.

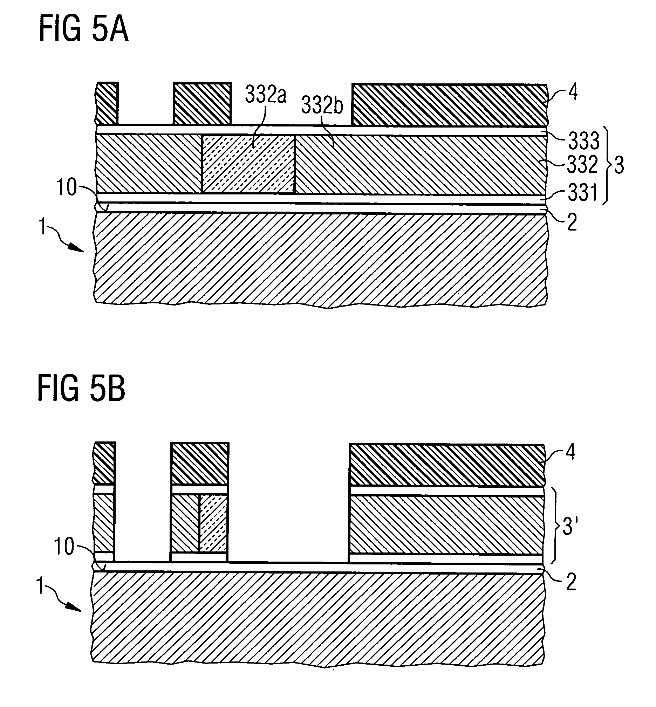

In der Fig. 5A ist gegenüber Fig. 1 die Prozessschicht 3 als Schichtstapel mit einer ersten, zweiten und dritten Stapelschicht 331, 332, 333 ausgebildet. In diesem Ausführungsbeispiel ist die zweite Stapelschicht 332 strukturiert und weist erste und zweite Stapelschichtabschnitte 332a, 332b aus verschiedenen Materialien auf. Das Material der ersten Stapelschicht ist etwa Siliziumoxid, das der dritten Stapelschicht Siliziumnitrid. Die Materialien des ersten bzw. zweiten Stapelschichtabschnitts 332a, 332b sind Silizium und Siliziumnitrid. Die zweite Stapelschicht 332 ist gemäß einer Sekundärstruktur strukturiert. Eine auf der Prozessschicht 3 aufliegende Ätzmaske 4 ist gemäß einer Primärstruktur, die unabhängig von der Sekundärstruktur ist, strukturiert. Die Primärstruktur der Ätzmaske 4 wird durch einen auf alle siliziumhaltigen Materialien der Prozessschicht 3 wirkenden Ätzprozess unabhängig von der in der Prozessschicht 3 realisierten Sekundärstruktur in die Prozessschicht 3 unter Zuhilfenahme der erfindungsgemäßen Ätzsignalschicht 2 abgebildet.

Das Ergebnis der Strukturierung der Prozessschicht 3 sowie die auf diese Weise erhaltene strukturierte Prozessschicht 3' ist in der Fig. 5B dargestellt.

Das in der Fig. 5 dargestellte Ausführungsbeispiel lässt sich mit den Ausführungsbeispielen der Fig. 2 bis 4 kombinieren.

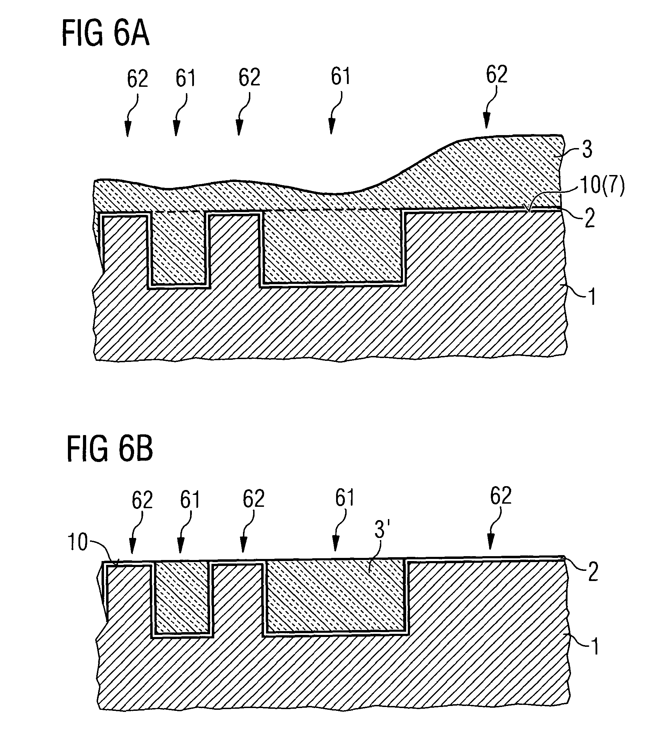

Die Fig. 6 bezieht sich auf einen CMP-Prozess als erfindungsgemäß verwendeter Ätzprozess. In einem Substrat 1 sind Gräben 61 eingebracht, die zusammen mit Stegen 62 eine Substratoberfläche 10 des Substrats 1 reliefartig strukturieren. Auf der Substratoberfläche 10 ist eine Ätzsignalschicht 2 aufgebracht, die das Substrat 1 maximal 20 nm dick, homogen, gleichmäßig und mit guter Kantenbedeckung abdeckt. Die Gräben 61 werden im Zuge einer Gasphasenabscheidung gefüllt, wobei das Füllmaterial sich auch oberhalb einer Oberkante der Gräben 61 abscheidet und eine Prozessschicht 3 ausbildet.

Die Prozessschicht 3 wird oberhalb der Substratoberfläche 10 im Zuge eines chemisch-mechanischen Polierprozesses abgetragen. Bei Detektion eines Ätzsignals, das durch freigelegte Abschnitte der Ätzsignalschicht 2 erzeugt wird, wird der Polierprozess beendet. In der Fig. 6B ist die auf diese Weise strukturierte und in die Gräben 61 zurückgebildete Prozessschicht 3' dargestellt.

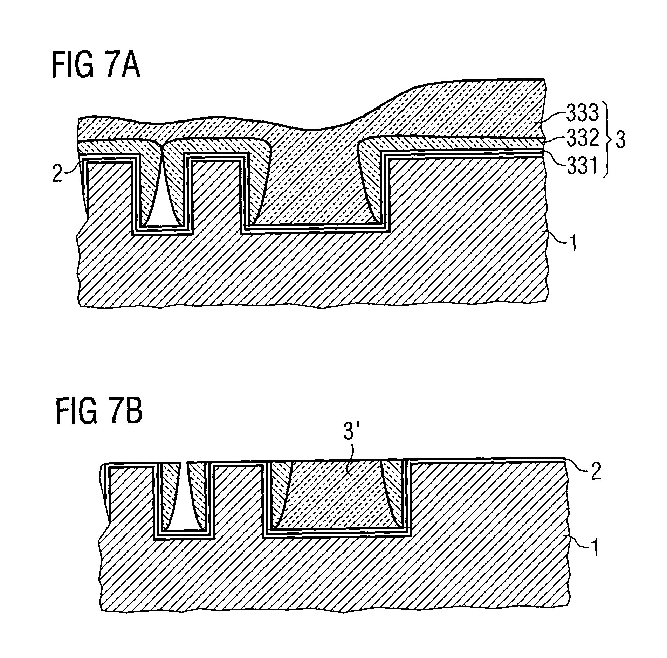

Im Ausführungsbeispiel der Fig. 7 ist gegenüber dem in der Fig. 6 dargestellten Ausführungsbeispiel die Prozessschicht 3 als Schichtstapel mit einer ersten, zweiten und dritten Stapelschicht 331, 332, 333 dargestellt.

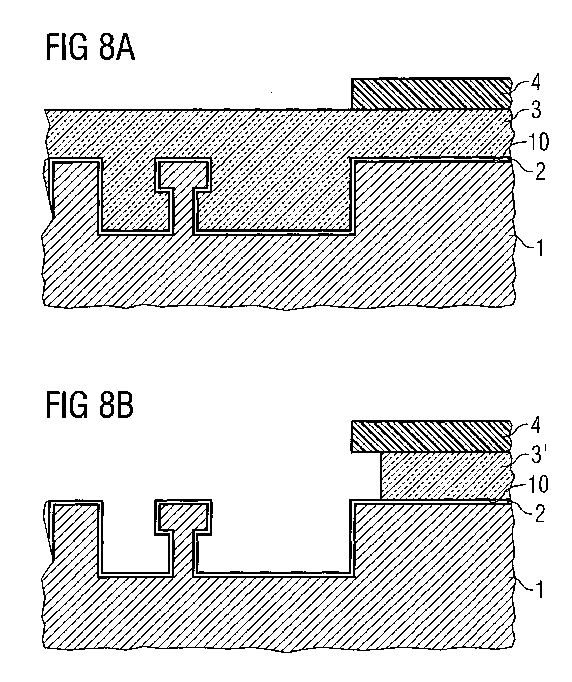

Die Fig. 8 zeigt das erfindungsgemäße Ätzverfahren im Zusammenhang mit einem isotropen Ätzprozess. In der Fig. 8a ist ein Substrat 1 mit einer strukturierten Oberfläche 10 dargestellt. Eine Ätzsignalschicht 2 ist als konforme Beschichtung des Substrats 1 im Bereich der Substratoberfläche 10 ausgebildet. An die Ätzsignalschicht 2 schließt eine Prozessschicht 3 mit planarer Oberfläche an. Auf der Prozessschicht 3 liegt eine strukturierte Ätzmaske 4 auf. Die Prozessschicht 3 wird gemäß der Struktur der Ätzmaske 4 in einem Ätzprozess mit isotropem Anteil strukturiert. Das Ergebnis ist in der Fig. 8b dargestellt. Durch die konforme Ausbildung der Ätzsignalschicht 2 lassen sich auch komplexe Strukturen sicher gegen isotrope Ätzprozesse schützen.

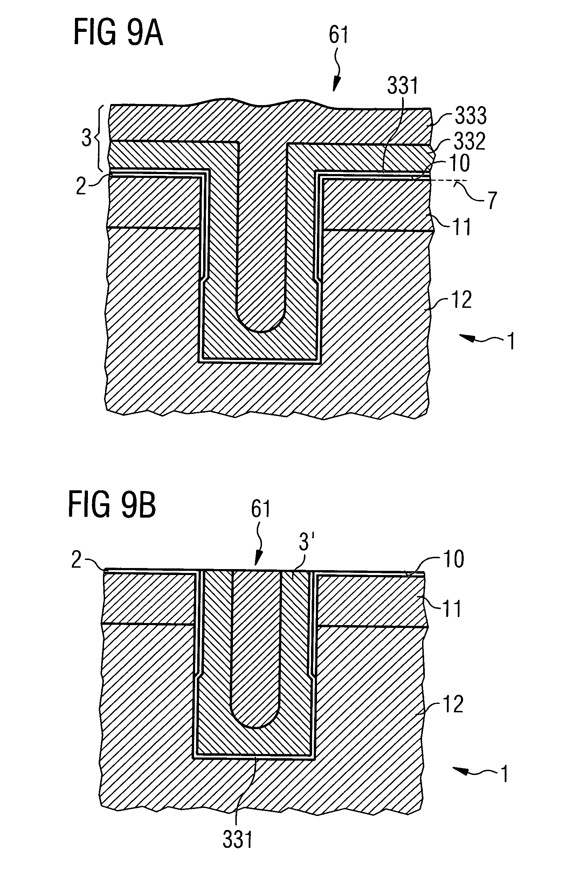

In ein zwei Abschnitte 11, 12 aufweisendes Substrat 1 der Fig. 9a ist ein Graben 61 eingebracht. Innerhalb der zweiten Teilschicht 12 des Substrats 1 ist eine leitfähige Struktur ausgebildet, die mit einer Füllung des Grabens 61 bei geringem Übergangswiderstand leitfähig zu verbinden ist. Die Füllung des Grabens 61 ergibt sich aus einer Schichtfolge verschiedener Materialien, die jeweils konform abgeschieden werden. Es ergibt sich als Prozessschicht 3 ein Schichtstapel mit drei Stapelschichten 331, 332, 333. Der Schichtstapel ist etwa durch ein chemisch-mechanisches Polierverfahren oberhalb der durch eine Oberkante des Grabens 61 gebildeten Substratkante 7 zurückzubilden. Dazu wird eine Ätzsignalschicht 2 vertikal strukturiert abgeschieden. Die Ätzsignalschicht 2 bedeckt horizontale Abschnitte der Substratoberfläche 10 im Bereich der Grabenkante 7 sowie obere vertikale Abschnitte des Grabens 61.

Durch einen chemisch-mechanischen Polierprozess wird die Prozessschicht 3' in die Gräben 61 zurückgebildet. Zwischen der zweiten Teilschicht 12, in der leitfähige Strukturen ausgebildet werden und der Füllung des Grabens 61 bzw. der strukturierten Prozessschicht 3' befindet sich kein Anteil einer dielektrischen Ätzsignalschicht, die einen Übergangswiderstand zwischen leitfähigen Endstrukturen in der zweiten Teilschicht 12 und der Füllung 3' erhöhen.

### Bezugszeichenliste

- 1: Substrat
- 1': strukturiertes Substrat
- 10: Substratoberfläche
- 11: erste Teilschicht
- 12: zweite Teilschicht
- 2: Ätzsignalschicht
- 2': strukturierte Ätzsignalschicht
- 3: Prozessschicht
- 3': strukturierte Prozessschicht
- 31: erste Prozessteilschicht
- 31': strukturierte erste Prozessteilschicht
- 32: zweite Prozessteilschicht
- 32': strukturierte zweite Prozessteilschicht
- 331: erste Stapelschicht
- 332: zweite Stapelschicht
- 332a: erster Stapelschichtabschnitt
- 332b: zweiter Stapelschichtabschnitt
- 333: dritte Stapelschicht
- 4: Ätzmaske
- 61: Graben
- 62: Steg
- 7: Substratkante
- dx: Nachlauf

## Patentansprüche

1. Ätzverfahren zum Abtrag von Material im Zuge einer Prozessierung von Halbleiterwafern mit den Schritten
- Bereitstellen eines Halbleiterwafers als Substrat (1),
- Vorsehen einer Ätzsignalschicht (2) mindestens auf Abschnitten einer Substratoberfläche (10) des Substrats (1),
- Vorsehen einer Prozessschicht (3) mindestens auf Abschnitten der Ätzsignalschicht (2),
- Abtragen von mindestens Abschnitten der Prozessschicht (3) im Zuge eines Ätzprozesses,
- Erzeugen eines Ätzsignals beim Freilegen von den abgetragenen Abschnitten der Prozessschicht (3) unterliegenden Abschnitten der Ätzsignalschicht (2) und
- Beenden des Ätzprozesses in Abhängigkeit des Ätzsignals,
**dadurch gekennzeichnet,**
**dass** die Ätzsignalschicht (2) mittels sequentieller Gasphasenabscheidung oder Molekularstrahlepitaxie als dielektrische Schicht aus einem Metalloxid oder einem Oxid seltener Erden vorgesehen wird.

2. Ätzverfahren nach Anspruch 1,
**dadurch gekennzeichnet,**
**dass** die Ätzsignalschicht (2) aus HfO₂, ZrO₂, Ta₂O₅, Al₂O₃, Pr₂O₅, La₂O₃ oder Nb₂O₅ vorgesehen wird.

3. Ätzverfahren nach einem der Ansprüche 1 oder 2,
**dadurch gekennzeichnet,**
**dass** die Ätzsignalschicht (2) in einer Schichtdicke vorgesehen wird, bei der ein signifikanter, auf dem quantenmechanischen Tunneleffekt beruhender Ladungsträgertransport durch die Ätzsignalschicht ermöglicht wird.

4. Ätzverfahren nach einem der Ansprüche 1 bis 3,
**dadurch gekennzeichnet, dass**
die Ätzsignalschicht (21) in einer Schichtdicke kleiner 20 Nanometer abgeschieden wird.

5. Ätzverfahren nach einem der Ansprüche 1 bis 4,
**dadurch gekennzeichnet, dass**
- die Ätzsignalschicht (2) aus einem Material mit einem in der Prozessschicht (3) nicht enthaltenen Signalelement vorgesehen wird,
- eine in Abhängigkeit vom Fortschritt des Ätzprozesses von der Prozessschicht (3) und/oder der Ätzsignalschicht (2) gebildete Prozessfläche (5) spektroskopisch beobachtet wird und
- das Ätzsignal bei spektroskopischer Detektion des Signalelements erzeugt wird.

6. Ätzverfahren nach einem der Ansprüche 1 bis 5,
**dadurch gekennzeichnet, dass**
- während des Ätzprozesses laufend eine Ätzrate des Ätzprozesses erfasst und
- das Ätzsignal bei einer signifikanten Änderung der Ätzrate erzeugt wird.

7. Ätzverfahren nach einem der Ansprüche 1 bis 6,
**dadurch gekennzeichnet,**
**dass** der Ätzprozess bei Detektion des Ätzsignals gestoppt wird.

8. Ätzverfahren nach einem der Ansprüche 1 bis 6,
**dadurch gekennzeichnet,**
**dass** der Ätzprozess nach einer ersten Nachlaufzeit beendet wird, wobei die erste Nachlaufzeit so bemessen wird, dass während der ersten Nachlaufzeit die Ätzsignalschicht (2) in den freigelegten Abschnitten gerade vollständig abgetragen wird.

9. Ätzverfahren nach einem der Ansprüche 1 bis 6,
**dadurch gekennzeichnet,**
**dass** der Ätzprozess nach Ablauf einer zweiten Nachlaufzeit beendet wird.

10. Ätzverfahren nach Anspruch 9,
**dadurch gekennzeichnet,**
**dass** die zweite Nachlaufzeit so bemessen wird, dass während der zweiten Nachlaufzeit das Substrat (1) in den freigelegten Abschnitten unterliegenden Abschnitten bis gerade zu einer für die Anwendung erforderlichen Tiefe abgetragen wird.

11. Ätzverfahren nach Anspruch 9,
**dadurch gekennzeichnet, dass**
- vor dem Vorsehen der Ätzsignalschicht (2) auf der Substratoberfläche (10) eine erste Prozessteilschicht (31) sowie nach dem Vorsehen der Ätzsignalschicht (2) eine zweite Prozessteilschicht (32) mindestens auf Abschnitten der Ätzsignalschicht (2) aufgebracht und
- die zweite Nachlaufzeit so bemessen wird, dass während der zweiten Nachlaufzeit die zweite Prozessteilschicht (32) inden den freigelegten Abschnitten unterliegenden Abschnitten gerade vollständig abgetragen wird.

12. Ätzverfahren nach einem der Ansprüche 1 bis 11,
**dadurch gekennzeichnet,**
**dass** in Abhängigkeit von einer Registrierung des Ätzsignals Parameter des Ätzprozesses geändert werden.

13. Ätzverfahren nach einem der Ansprüche 1 bis 12,
**dadurch gekennzeichnet,**
**dass** die Prozessschicht (3) aus mehr als einer Stapelschicht (331, 332, 333, ..) ausgebildet wird.

14. Ätzverfahren nach Anspruch 13,
**dadurch gekennzeichnet,**
**dass** mindestens eine der Stapelschichten (331, 332, 333, ..) mit einer Sekundärstruktur mit mehreren Stapelschichtabschnitten (332a, 332b) aus unterschiedlichen Materialien vorgesehen wird.

15. Ätzverfahren nach einem der Ansprüche 13 oder 14,
**dadurch gekennzeichnet,**
jeweils mindestens eine erste der Stapelschichten (331, 332, 33, ..) abschnittsweise oder vollständig aus Silizium, eine zweite abschnittsweise oder vollständig aus Siliziumoxid und eine dritte abschnittsweise oder vollständig aus Siliziumnitrid vorgesehen wird.

16. Ätzverfahren nach einem der Ansprüche 1 bis 15,
**dadurch gekennzeichnet,**
**dass** das Substrat (1) mit einem gemäß einer Grundstruktur strukturierten Relief (6) mit Gräben (61) und Stegen (62) an der Substratoberfläche (10) bereitgestellt wird.

17. Ätzverfahren nach einem der Ansprüche 1 bis 16,
**dadurch gekennzeichnet,**
**dass** auf der Prozessschicht (3) eine gemäß einer Primärstruktur strukturierte Maske (4) vorgesehen und durch den Ätzprozess die Primärstruktur mindestens bis in die Prozessschicht (3) übertragen wird.

18. Ätzverfahren nach Anspruch 17,
**dadurch gekennzeichnet,**
**dass** die Sekundärstruktur unterschiedlich zur Primärstruktur vorgesehen wird.

19. Ätzverfahren nach Anspruch 16,
**dadurch gekennzeichnet, dass**
- durch eine Oberkante eines bezüglich der Substratoberfläche (10) höchsten Steges (62) eine Substratkante (7) bestimmt wird,
- der Ätzprozess als ein chemisch-mechanisches Polierverfahren durchgeführt wird und
- und im Zuge des Ätzprozesses oberhalb der Substratkante (7) angeordnete Abschnitte der Prozessschicht (3) abgetragen werden.

20. Ätzverfahren nach Anspruch 19,
**dadurch gekennzeichnet, dass**
die Ätzsignalschicht (2) strukturiert vorgesehen wird.

21. Ätzverfahren nach Anspruch 20,
**dadurch gekennzeichnet, dass**
die Ätzsignalschicht (2) durch eine sequentielle Gasphasenabscheidung aus einer Mehrzahl von molekularen Einzellagen zusammengesetzt vorgesehen wird, wobei die Abscheidung jeder Einzellage gerichtet von der Substratkante (7) aus in die Tiefe des Reliefs (6) erfolgend gesteuert wird und durch Abbruch der Abscheidung jeder Einzellage vor einer vollständigen Bedeckung die Ätzsignalschicht (2) vertikal strukturiert erzeugt wird.

22. Ätzverfahren nach einem der Ansprüche 1 bis 21,
**dadurch gekennzeichnet, dass**
die Ätzsignalschicht (2) durch einen Wärmeschritt verdichtet wird.

23. Ätzsignalschicht aus einem Metalloxid oder einem Oxid seltener Erden gemäß einem der Ansprüche 1 bis 22,
**dadurch gekennzeichnet,**
**dass** die Ätzsignalschicht (2) mittels einer sequentiellen Gasphasenabscheidung oder Molekularstrahlepitaxie als Schichtsystem aus einer Mehrzahl von einmolekularen Einzellagen in einer Schichtdicke vorgesehen ist, bei der ein signifikanter auf dem quantenmechanischen Tunneleffekt beruhender Ladungsträgertransport durch die Ätzsignalschicht (2) möglich ist.

24. Ätzsignalschicht nach Anspruch 23,
**gekennzeichnet durch**
eine Schichtdicke von weniger als 20 Nanometern.
